# EUROPEAN PATENT APPLICATION

(11) **EP 4 391 072 A1**
(43) Date of publication of application: **26.06.2024**
(21) Application number: 22214777.9
(22) Date of filing: 19.12.2022
(51) Int. Cl.: H01L 29/423, H01L 29/78, H01L 21/336

(54) **TRANSISTOR DEVICE AND METHOD FOR PRODUCING THEREOF**

(71) Applicant: Infineon Technologies Austria AG, 9500 Villach (AT)
(72) Inventor: WEBER, Hans, 83457 Bayerisch Gmain (DE)
(74) Representative: Westphal, Mussgnug & Partner, Patentanwälte mbB

(57) **Abstract**

A transistor device and a method for forming a transistor device are disclosed. The transistor includes at least one transistor cell (1) having active device regions integrated in an inner region (110) of a semiconductor body (100); a gate via (32) extending, in an edge region (120) of the semiconductor body, through the semiconductor body (100) from a first surface (101) to a second surface of the semiconductor body; a drain pad (52) and a gate pad (34) each formed on top of the second surface (102) of the semiconductor body; and an insulating structure (2) arranged between the inner region (110) and the gate via (32) and extending through the semiconductor body (100) from the first surface (101) to the second surface (102). The gate via (32) is connected between the at least one transistor cell (1) and the gate pad (34). The insulating structure (2) includes: an insulating trench (21) extending from the first surface (101) into the semiconductor body (100) and being spaced apart from the second surface (102), and an insulating plug (22) extending from the second surface (102) to the insulating trench (21).

## Description

This disclosure relates in general to, transistor device, in particular, a source down transistor device.

A source-down transistor device is a transistor device in which a source electrode (source pad) is arranged above a first surface of a semiconductor body (semiconductor die) in which active regions of the transistor device are integrated. A drain electrode (drain pad) and a gate pad are arranged above a second surface opposite the first surface of the semiconductor die.

There is a need to provide a source-down transistor device that can be produced in an efficient way.

One example relates to a transistor device. The transistor device includes at least one transistor cell having device regions integrated in an inner region of a semiconductor body, and a gate via extending, in an edge region of the semiconductor body, through the semiconductor body from a first surface to a second surface of the semiconductor body. The transistor devices further includes a drain pad and a gate pad each formed on top of the second surface of the semiconductor body, and an insulating structure arranged between the inner region and the gate via and extending through the semiconductor body from the first surface to the second surface. The gate via is connected between the at least one transistor cell and the gate pad. The insulating structure includes an insulating trench extending from the first surface into the semiconductor body and being spaced apart from the second surface, and an insulating plug extending from the second surface to the insulating trench.

Examples are explained below with reference to the drawings. The drawings serve to illustrate certain principles, so that only aspects necessary for understanding these principles are illustrated. The drawings are not to scale. In the drawings the same reference characters denote like features.
Figure 1 schematically illustrates a vertical cross-sectional view of a source-down transistor device according to one example, wherein the transistor devices includes at least one transistor cell in an inner region of the semiconductor body, a gate via in an edge region of the semiconductor body, and an insulating structure arranged between the inner region and the gate via;
Figures 2A-2B illustrate a vertical cross-sectional view and a top view of a source-down transistor device of the type illustrated in Figure 1 according to one example;
Figures 3A-3B illustrate a vertical cross-sectional view and a top view of a source-down transistor device of the type illustrated in Figure 1 according to another example;
Figure 4 illustrates one example of a transistor devices of the type illustrated in Figure 1 in greater detail;
Figure 5 illustrates a modification of the insulating structure illustrated in Figure 1;
Figures 6A-6C illustrate one example of a method for forming the insulating structure and the gate via in a transistor device of the type illustrated in Figure 1;
Figures 7A-7G illustrate one example of a method for forming portions of the insulating structure and the gate via and for forming gate and drain pads;
Figures 8A-8H illustrate one example of a method for forming other portions of the insulating structure and the gate via;
Figures 9A-9C illustrate one example of a method for connecting the gate via to a gate conductor formed on top of a first surface of the semiconductor body;
Figures 10A-10B illustrate one example of a method for forming an insulating trench and a via trench, wherein the via trench extends deeper into the semiconductor body than insulating trench;
Figures 11A- 11G illustrate one example of a method for forming a void in a trench of the insulating structure;
Figures 13A-13G illustrate a method for forming transistor cells according to one example;
Figure 14 illustrates a horizontal cross-sectional view of a gate conductor of the transistor cell according to Figure 13G;
Figure 15 illustrates a modification of the transistor cell illustrated in Figure 13G;
Figure 16 illustrates transistor cells according to another example;
Figure 17 illustrates a horizontal cross-sectional view of a gate conductor of the transistor cells according to Figure 16 according to one example;
Figure 18 illustrates a horizontal cross-sectional view of a gate conductor of the transistor cells according to Figure 15 according to another example
Figure 19 illustrates a modification of a transistor cells illustrated in Figure 16;
Figure 20 illustrates one example of connecting 8 electrodes in the transistor cells according to Figure 19 to the gate via; and
Figure 21 illustrates transistor cells according to another example.

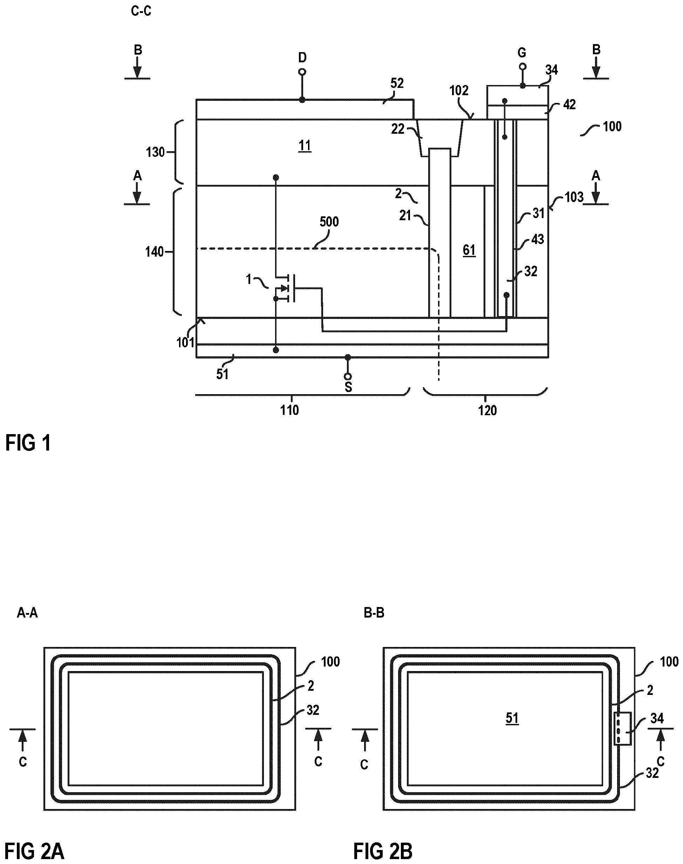

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise. Figure 1 illustrates a vertical cross-sectional view of a source-down transistor device according to one example. Referring to Figure 1, the transistor device includes a semiconductor body 100 and at least one transistor cell 1 having active device regions integrated in an inner region 110 of the semiconductor body 100. Active device regions of the at least one transistor cell 1 include body and source regions, for example. Examples of the active device regions and examples for implementing the at least one transistor cell 1 are explained in detail herein further below.

The semiconductor body 100 may include a conventional monocrystalline semiconductor material, such as silicon (Si) or silicon carbide (SiC).

In Figure 1, one or more transistor cells 1 of the transistor device are schematically illustrated by the circuit symbol of a transistor. The second symbol illustrated is the circuit symbol of a MOSFET, in particular, an N-type enhancement MOSFET. The transistor device, however, is not restricted to be implemented as an N-type enhancement MOSFET but may be implemented as any other type of transistor device with or without an insulating gate as well. Examples of other type of transistor devices with an insulating gate include any other type of MOSFET (Metal Oxide Field-Effect Transistor) or an IGBT (Insulated Gate Bipolar Transistor). Examples of transistor devices without insulating gate include any type of JFET (Junction Field-Effect Transistor) or any type of BJT (Bipolar Junction Transistor).

Referring to Figure 1, the transistor device further includes a gate via 32. The gate via 32 is arranged in a trench 31 and extends through the semiconductor body 100 from a first surface 101 of the semiconductor body 100 to a second surface 102 opposite the first surface 101. Trench 31 is also referred to as via trench in the following. The gate via 32 is arranged in an edge region 120 of the semiconductor body 100. The edge region 120 is arranged between the inner region 110 and an edge surface 103, wherein the edge surface 103 terminates the semiconductor body 100 in lateral directions. "Lateral directions" are directions perpendicular to a vertical direction, which is a direction that is essentially perpendicular to the first and second surfaces 101, 102. According to one example, the edge region 120 surrounds the inner region 110 in lateral directions of the semiconductor body 100.

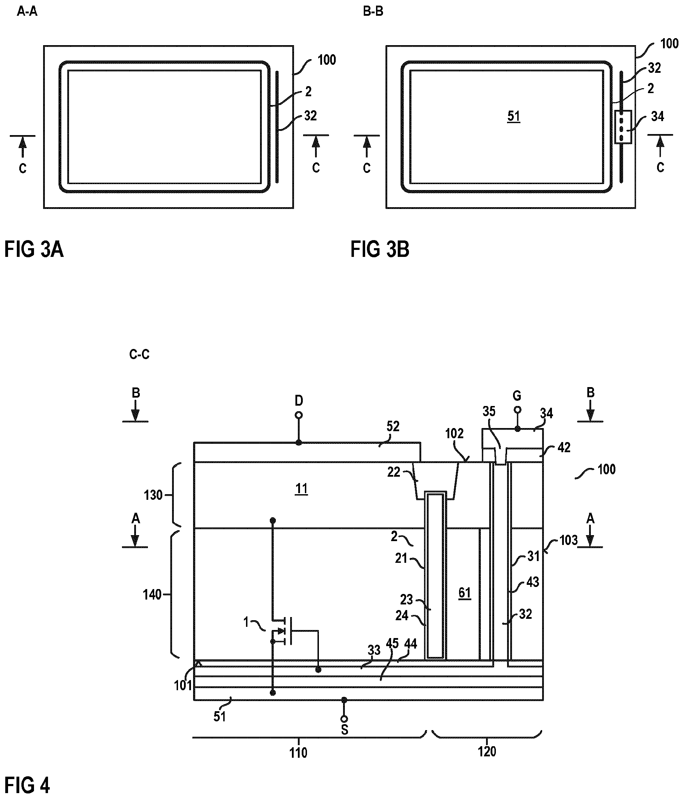

In Figure 1, only one edge surface 103 of the semiconductor body 100 is illustrated. According to one example, the semiconductor body 100 has a rectangular shape (as illustrated in Figures 2A, 2B and 3A, 3B, for example) and includes four edge surfaces.

Referring to Figure 1, the gate via 32 may be electrically insulated from semiconductor regions of the semiconductor body 100 by an insulating layer 43. The insulating layer 43 is arranged between the gate via 32 and semiconductor regions of the semiconductor body 100 and provides for an electric insulation between the gate via 32 and the semiconductor regions.

Furthermore, the transistor device includes an insulating structure 2 arranged in the semiconductor body 100 between the inner region 110 and the gate via 32. The insulating structure 2 extends through the semiconductor body 100 from the first surface 101 to the second surface 102 and includes an insulating trench 21 and an insulating plug 22. The insulating trench 21 extends from the first surface 101 into the semiconductor body 100 and is spaced apart from the second surface 102. The insulating plug 22 extends from the second surface 102 to the insulating trench 21.

Furthermore, the transistor device includes a drain pad (drain electrode) 52 and a gate pad 34 that are each formed on top of the second surface 102. The gate via 32 is connected between the gate pad 34 and the at least one transistor cell 1. The gate pad 34 forms a gate node G of the transistor device or is connected to a gate node of the transistor device. The drain pad 52 forms a drain node D of the transistor device or is connected to a drain node of the transistor device.

The drain pad 52 is connected to a drain region 11 of the transistor device. The drain region 11 is a doped region of the semiconductor body 100 adjoining the second surface 102. According to one example, for connecting the drain pad 52 to the drain region 11, the drain pad 52 adjoins the second surface 102 of the semiconductor body 100. The drain region 11 may be a contiguous semiconductor region that forms the drain region of each of the one or more transistor cells 1.

According to one example, the transistor device further includes a source electrode or source pad 51 formed on top of the first surface 101 and connected to each of the one or more transistor cells 1 of the transistor device. More specifically, the source electrode 51 is connected to the source region (not illustrated in Figure 1) of each of the one or more transistor cells 1. Such connection between the source electrode 51 and the one or more transistor cells 1 is only schematically illustrated in Figure 1. More detailed examples are explained herein further below. The source electrode 52 forms a source node S of the transistor device.

Referring to Figure 1, the semiconductor body 100 may include a first semiconductor layer 130 and a second semiconductor layer 140 adjoining the first semiconductor layer 130. According to one example, the first semiconductor layer 130 is a semiconductor substrate and the second semiconductor layer 140 is an epitaxial layer formed on top of the substrate. According to one example, the first semiconductor layer 130 forms the drain region 11 of the transistor device in the inner region 110. Active device regions, such as body and source regions, of the at least one transistor cell 1 are integrated in the second semiconductor layer 140.

According to one example, the insulating structure 2, in lateral directions of the semiconductor body 100, forms a ring around the inner region 110 with the at least one transistor cell 1 and, therefore, provides for an electric insulation between semiconductor regions of the semiconductor body 100 included in the inner region 110 and semiconductor regions of the semiconductor body 100 included in the edge region 120.

Figures 2A and 2B illustrate one example of a ring-shaped insulating structure 2 of the transistor device. Figure 2A schematically illustrates a horizontal cross-sectional view of the transistor device in a section plane A-A illustrated in Figure 1, and Figure 2B illustrates a top view of the transistor device onto the second surface 102 (plane B-B illustrated in Figure 1). The insulating structure 2 and the gate via 32 are schematically drawn as the bold lines in Figures 2A and 2B.

As can be seen from Figures 2A and 2B, the insulating structure 2, in lateral directions of the semiconductor body 100, forms a ring around the inner region of the semiconductor body 100. As illustrated, the gate via 32 may also be implemented as a ring that surrounds the inner region 110 in lateral directions of the semiconductor body 100, wherein the gate via 32 is arranged between the insulating structure 2 and the edges surfaces of the semiconductor body 100. In Figure 2B, the position of the gate via 32 below the gate pad 34 is illustrated in dashed lines.

It should be noted that the transistor device may include a passivation layer at least on top of sections of the second surface 102 not covered by the drain pad 51 or the gate pad 34. Such passivation layer, however, is not illustrated in the drawings.

Figures 3A and 3B illustrate a horizontal cross-sectional view and a top view of a transistor device according to another example. In this example, the insulating structure 2, in the lateral directions, forms a ring around the inner region 110. The gate via 32, different from the example illustrated in Figures 2A and 2B, does not surround the inner region 110 but is implemented as an elongated structure extending along one of the edge surfaces and the insulating structure 2.

The transistor device illustrated in Figure 1, may be operated in a conducting state (on-state) or a blocking state (off-state). In both operating states, an electrical potential of the semiconductor regions in the edge region 120 essentially equals the electrical potential of the source electrode 51. In the off-state, the electrical potential at the drain node D and, therefore, the electrical potential of the drain region 11 may be significantly different from the electrical potential at the source node S and the source electrode 51. The voltage blocking capability of the transistor device is the maximum voltage difference the transistor device can withstand between the drain node D and the source node S, wherein a current generating event, e.g. an Avalanche breakdown, may occur when the voltage becomes higher than the voltage blocking capability. The insulating structure 2 is capable of withstanding a voltage that is equal to or higher than the maximum voltage blocking capability of the transistor device in order to prevent that a voltage breakdown occurs between the inner region 110 and the edge region 120.

In Figure 1, the dashed line labeled with reference number 500 schematically illustrates one equipotential line that may occur in the transistor device in the blocking stage. As can be seen from Figure 1, in the inner region 110, equipotential lines, such as equipotential line 500, are essentially parallel to the first and second surfaces 101, 102. The equipotential lines enter the insulating trench 21 and, in the insulating trench 21, are bend towards the first surface 101. The equipotential lines are essentially parallel in the insulating trench 21 and leave the insulating trench 21 at the first surface 101 of the semiconductor body 100. That is, the equipotential lines do not enter the edge region 120 of the semiconductor body 100.

The insulating trench 21 may include a high-quality insulation layer, such as a thermally grown oxide layer. In the transistor device according to Figure 1, in which the insulating structure 2 includes the insulating trench 21 and the insulating plug 22, the insulating trench 21 with the high-quality insulation layer may be formed as part of processes in which the first surface 101 of the semiconductor body 100 is accessible for processing. These processes are processes in which the one or more transistor cells are formed, for example, and are referred to as frontside processes in the following. These processes may also be referred to as FEOL (front-end of line) processes. A high-temperature oxidation process, such as an oxidation process that may be used to form the high-quality insulation layer in the insulating trench 21, is available as an FEOL process. This is explained in detail herein further below.

Figure 4 illustrates a vertical cross-sectional view of a transistor device of the type illustrated in Figure 1 in greater detail. In the transistor device according to Fig-ure 4, the insulating trench 21 includes an insulating layer 24, and a void 23 separated from the insulating layer 24 by regions of the semiconductor body 100. The insulating layer 24 includes a thermally grown oxide layer, for example. According to one example, the void 23 includes a vacuum, so that the pressure in the void 23 is below atmospheric pressure.

Furthermore, in the example illustrated in Figure 4, the gate via 32 is connected to the gate pad 34 through a contact plug 35 that extends from the gate pad 34 through an insulating layer 42 to the gate via 32. The insulating layer 42 is formed on top of the second surface 102 and provides for an insulation between the gate pad 34 and semiconductor regions of the semiconductor body 100.

Furthermore, in the example illustrated in Figure 4, the transistor device includes a gate conductor 33 that is formed on top of the first surface 101 and that is connected to the gate via 32. According to one example, the gate conductor 33 is connected to gate electrodes of the one or more transistor cells 1. According to another example, portions of the gate conductor 33 form gate electrodes of the one or more transistor cells 1. Both examples are explained in detail herein further below.

The gate conductor 33 is dielectrically insulated from the semiconductor body 100 by an insulating layer 44, which is referred to as gate insulation layer in the following. Details of the gate insulation layer 44 are also explained herein further below. The source electrode 51 is electrically insulated from the gate conductor 33 by a further insulating layer 45, which is referred to as gate-source insulation layer in the following.

In the examples illustrated in Figures 1 and 4, the insulating structure 2 includes one insulating trench 21 extending between the first surface 101 and the insulating plug 22. This, however, is only an example. According to another example, the insulating structure 2 includes two or more insulating trenches 21 each extending from the first surface 101 to the insulating plug 22.

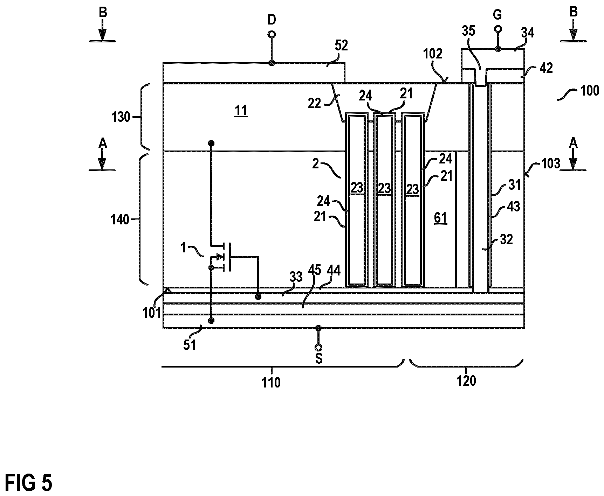

Figure 5 illustrates one example of a transistor device in which the insulating structure 2 includes several insulating trenches 21. Just for the purpose of illustration, the insulating structure 2 according to Figure 5 includes three insulating trenches 21. However, the insulating structure 2 could also be implemented with only two or with more than three insulating trenches 21. Each of the insulating trenches 21 forms a ring around the inner region 110.

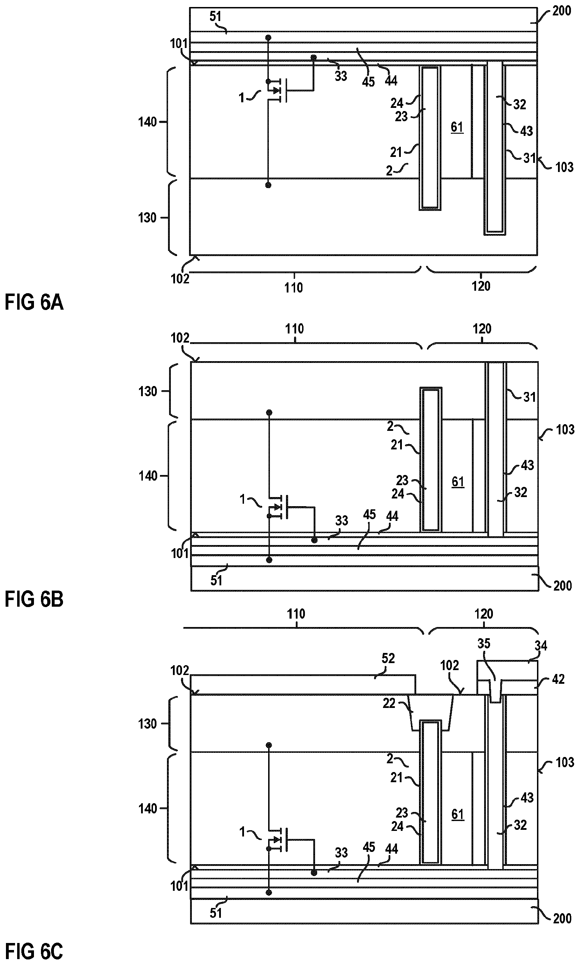

Figures 6A-6C illustrate one example of a method for forming the insulating structure 2 and the gate via 32. Each of these figures shows a vertical cross-sectional view of the transistor device after respective process sequences.

Figure 6A illustrates the transistor device after frontside processes have been finished. These processes include forming the at least one transistor cell 1, the gate insulator 44 on top of the first surface 101, the gate conductor 33 on top of the gate insulator 44, the gate-source insulator 45 on top of the gate conductor 33, and the source electrode 51. The frontside processes further include forming the insulating trench 21, and the insulating layer 24 and the void 23 within the insulating trench 21. Furthermore, the FEOL processes include forming the gate via 32, and the insulating layer 43 separating the gate via 32 from the semiconductor body 100.

Forming the insulating trench 21 includes forming a trench that extends from the first surface 101 through the second semiconductor layer 140 into the first semiconductor layer 130 and that is spaced apart from the second surface 102. Furthermore, forming the insulating trench 21 includes forming the insulating layer 24 and the void 23 within the trench. An example of a method for forming the insulating layer 24 and the void 23 are explained herein further below.

Forming the gate via 32 includes forming a gate via trench 31 that extends from the first surface 101 through the second semiconductor layer 140 into the first semiconductor layer 130 and that is spaced apart from the second surface 102. According to one example, the gate via trench 31 extends deeper into the first semiconductor layer 130 than the insulating trench 21, so that a distance between the insulating trench 21 and the second surface 102 is larger than a distance between the gate via trench 31 and the second surface 102.

According to one example, during the frontside processes, the semiconductor body 100 is mounted to some kind of carrier (not shown) with the second surface 102 facing the carrier, while the first surface 101 or the layers formed on top of the first surface 101 are accessible for processing.

Referring to Figure 6A, the frontside processes may be finished by forming a carrier 200 on top of the source electrode 51. Carrier 200 is a glass carrier, for example. Carrier 200, which may be much thicker than the semiconductor body 100, stabilizes the semiconductor body 100 during further process steps explained in the following.

It should be noted that the frontside processes explained herein before, as well as the process sequences explained with reference to Figure 6B and 6C in the following, may take place on a wafer level. That is, these process sequences may be applied to a plurality of semiconductor bodies included in a wafer at the same time. Thus, although the edge surface 103 is illustrated in Figures 6A-6C, these process sequences may take place before the wafer is subdivided into individual semiconductor bodies (semiconductor dies) and, therefore, before the edge surfaces 103 are formed. During the front side processes, the wafer may be held by a conventional wafer chuck.

The process sequences explained with reference to Figure 6B and 6C, are process sequences that require access to the second surface 102. These processes are referred to as back side processes in the following and may also be referred to as BEOL (back end of line processes) in the following. After finishing the frontside processes and forming the carrier 200 and before the backside BEOL processes, the semiconductor body 100 (the wafer including the semiconductor body 100) is flipped and the semiconductor body 100 (the wafer) is attached to some kind of handling device (not illustrated). More specifically, the carrier 200 is attached to the handling device such as a wafer chuck.

Referring to Figure 6B, the process sequences, after flipping the semiconductor body 100, include removing sections of the first semiconductor layer 130 down to the gate via trench 31 such that the insulating layer 43 at the bottom of the vie trench 31 is removed and the gate via 32 is exposed. This may include that a portion of the gate via 32 is also removed. The removal process may include at least one of an etching or polishing process. The removal process includes a CMP (chemical mechanical polishing) process, for example.

Referring to the above, the via trench 31 is formed such that it extends deeper from the first surface 101 into the semiconductor body 100 than the insulating trench 21. This helps to ensure that the process of removing sections of the first semiconductor layer 130 down to the gate via 32 stops before the first semiconductor layer 130 can be removed down to the insulating trench 21 and before the insulating trench can be opened.

Referring to Figure 6C, the method further includes forming the insulating plug 22 that extends from the second surface 102 to the insulating trench 21; forming the drain pad 52 on top of the first semiconductor layer 130 in the inner region 110; forming the gate pad 34 insulated from the semiconductor body 100 by the insulating layer 42 in the edge region 120; and connecting the gate pad 34 to the gate via 32. Connecting the gate pad 34 to the gate via 32 may include forming the conduct plug 35 that extends from the gate pad 34 through the insulating layer 42 to the gate via 32.

In the example illustrated in Figure 6A-6C, the insulating structure 2 includes only one insulating trench 21. This, however, is on an example. As outlined above, it is also possible to implement the insulating structure 2 with two or more insulating trenches 21.

Referring to the above, forming the insulating layer 24 in the insulating trench 21 may include a thermal oxidation process. Such thermal oxidation process may require temperatures of more than 700 °C and is available as one of the frontside processes. Thermal processes that are part of backside processes, however, should not exceed temperatures of 250 °C, for example. One reason is that glues that may be used to attach the carrier 200 to the source electrode 51 are not stable at temperatures higher than 250 °C.

Referring to the above, the carrier 200 stabilizes the wafer with the semiconductor body 100 during the backside processes. Such stabilization may become necessary, in particular, after removing portions of the first semiconductor layer 130, which results in a reduced thickness of the wafer.

It should be noted that the carrier 200 is optional and may be omitted when the wafer is sufficiently stable after removing portions of the first semiconductor layer 130. In this example, the source metallization 51 may directly be attached to a wafer handling device, such as a wafer chuck. Even in this case, however, high temperatures, such as temperatures higher than 700 °C, are undesirable as these temperatures may damage metallizations, such as the source metallization 51, formed on top of the first surface 101.

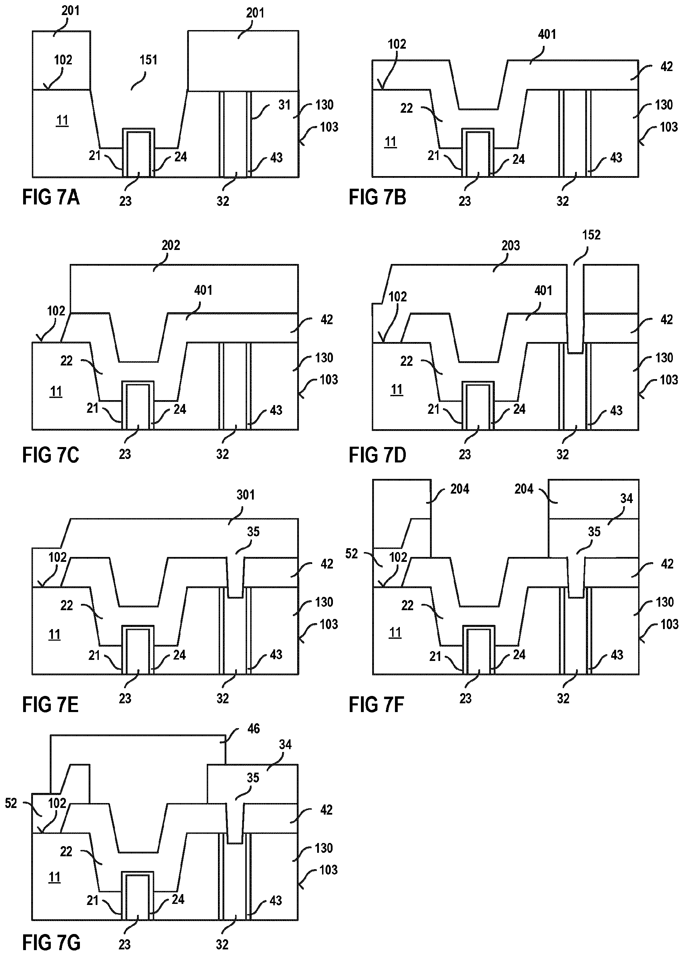

Figures 7A-7G illustrate one example of a method for forming the insulating plug 22, the drain pad 52, the gate pad 34 insulated from the semiconductor body 100 by the insulating layer 42, and the conduct plug 35. Each of Figures 7A-7G illustrate a vertical cross-sectional view of the semiconductor body 100 in a region of the second surface 102. In these figures, only sections of the insulating trench 21 and the gate via 32 are illustrated.

Referring to Figure 7A, after removing the first semiconductor layer 130 down to the via trench 31, the method includes forming a trench 151 that extends from the second surface 102 down to the insulating trench 21 with the insulating layer 24 and the void 23. Forming the trench 151 may include an etching process using an etch mask 201 formed on top of the second surface 102, wherein the etch mask includes an opening at the position where the trench 151 is to be formed in the second surface 102. The etching process is configured to etch the semiconductor material of the semiconductor body 100 selectively relative to the insulating layer 401, thereby leaving the insulating layer 24 intact. The trench 151 may be formed to extend beyond a lower end of the insulating trench 21. In this case (as illustrated) a section of the insulating layer 24 covering the void 21 may protrude from a bottom of the trench 151. The "lower end" of the insulating trench 21 is that end of the insulating trench 21 that faces the second surface 102.

Referring to Figure 7B, after removing the etch mask 201, the method includes forming an insulating layer 401 in the trench 151 and on top of the second surface 102. The insulating layer 401 entirely covers bottom and sidewalls of the trench 151 and may entirely cover the second surface 102. A portion of the insulating layer 401 formed in trench 151 forms the insulating plug 22. The insulating plug 22 electrically insulate the inner region of the semiconductor body 100 from the edge region. Furthermore, the insulating plug 22 mechanically stabilizes the semiconductor body 100 after forming the trench 151 down to the insulating trench 21.

Forming the insulating layer 401 may include a deposition process. According to one example, the insulating layer 401 comprises an oxide such as silicon dioxide (SiO₂). In this example, the insulating layer 401 may be formed based on depositing TEOS (tetraethoxysilane).

Referring to Figure 7C, the method further includes partially removing the insulating layer 401. Partially removing the insulating layer 401 includes removing the insulating layer 401 from those sections of the second surface 102 where the drain pad 52 is to be formed and leaving the insulating layer 401 on top of those sections where the gate pad 34 is to be formed. In other words, the insulating layer 401 is removed from the drain region 11 of the transistor device. Partially removing the insulating layer 401 may include an etching process that etches the insulating layer 401 selectively relative to the semiconductor body 100. The etching process may include forming an etch mask 202 that leaves those sections of the insulating layer 401 uncovered that are to be removed.

Referring to Figure 7D, the method further includes forming a contact opening 152 that extends through the insulating layer 42 and the via insulating layer 43 down to the gate via 32. Forming the opening 152 may include an etching process using an etch mask 203 that covers the remainder of the insulating layer 401 and sections of the second surface 102 not covered by the insulating layer 401.

Referring to Figure 7E, the method further includes forming an electrically conducting layer 301 on top of the insulating layer 42 and uncovered sections of the second surface 102. The electrically conducting layer 301 fills the contact opening in the insulating layer 42 and forms the contact plug 35.

Referring to Figure 7F, the method further includes patterning the electrically conducting layer 301 to form the drain pad 52 on top of the drain region 11 and the gate pad 34 on top of the insulating layer 42 and electrically connected to the gate via 32 by the contact plug 35. Patterning the electrically conducting layer 301 may include an etching process using an edge mask 204 that leaves those sections of the electrically conducting layer 301 uncovered where the electrically conducting layer 301 is to be removed. The electrically conducting layer 301 is a metal layer, such as a copper layer, for example. According to another example, the electrically conducting layer 301 includes a layer stack with several electrically conducting layer formed on top of each other including for example a copper (Cu) layer, a titanium (Ti) layer, and an aluminum (Al) layer.

Optionally, as illustrated in Figure 7G, a passivation layer 46 may be formed on top of the insulating layer 42 between the drain pad 52 and the gate pad 34. The passivation 46 layer is an imide layer, for example. The passivation layer 46 may help to protect the semiconductor body 100 against external impacts, such as substances from a mold compound (not illustrated) in which the semiconductor arrangement may finally be embedded. Furthermore, the passivation layer 46 may help to increase the dielectric strength between the drain pad 52 and the gate pad 34.

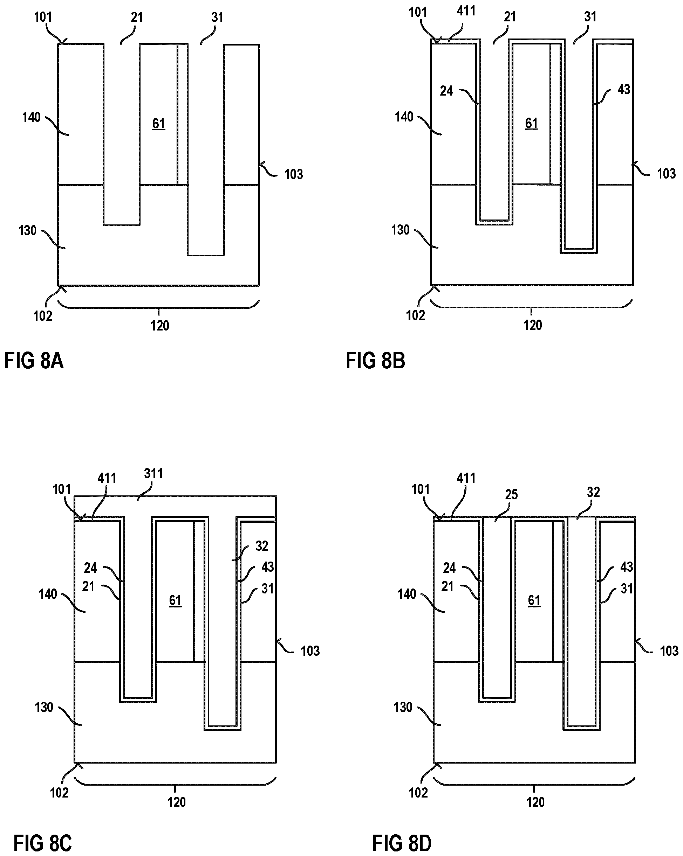

Figures 8A-8H illustrate one example of a method for forming the insulating trench 21 with the insulating layer 24 and the void 23 and for forming the gate via 32. Each of Figures 8A-8H illustrates a vertical cross-sectional view of the semiconductor body 100 in the edge region 120. The inner region 110 is not illustrated in these figures.

Referring to Figure 8A, the method includes forming the insulating trench 21 and the rear trench 31 such that both trenches extend from the first surface 101 through the second semiconductor layer 140 into the first semiconductor layer 130. Forming these trenches 21, 31 may include an etching process. A more detailed example of such etching process is explained herein further below.

Referring to Figure 8B, the method further includes forming an insulating layer 411 on bottoms and sidewalls of the trenches 21, 31 and on top of the first surface 101 of the semiconductor body 100. According to one example, the insulating layer 411 includes a thermally grown oxide layer adjoining the semiconductor body. In addition to the thermally grown oxide layer, the insulating layer 411 may include a further insulating layer deposited on top of the thermally grown oxide layer. According to one example, the further insulating layer is a deposited oxide layer, such as a TEOS layer. According to one example, the deposited oxide layer is deposited to have a thickness of between 100 nanometers (nm) and 1000 nanometers.

In the insulating trench 21, the insulating layer 411 forms at least a portion of the insulating layer 24 separating the void 23 from the semiconductor body 100 in the finished device. In the via trench 31, the insulating layer 411 forms the via insulating layer 43 separating the gate via 32 from the semiconductor body 100 in the finished device.

Referring to Figure 8C, the method further includes forming an electrically conducting layer 311 that fills the insulating trench 21 and the via trench 31. According to one example, forming the electrically conducting layer 311 includes depositing the electrically conducting layer 311. According to one example, the electrically conducting layer 311 is a highly doped polysilicon layer.

Referring to Figure 8D, the method further includes removing the electrically conducting layer 311 from above the first surface 101 and leaving the electrically conducting layer 311 in the trenches 21, 31. In the via trench 31, the electrically conducting layer 311 forms the gate via 32. In the insulating trench 21, the electrically conducting layer 311 forms a sacrificial layer 25 that is removed at a later stage of the manufacturing process. Removing the electrically conducting layer 311 from above the first surface 101 may include a planarizing process, such as a CMP process.

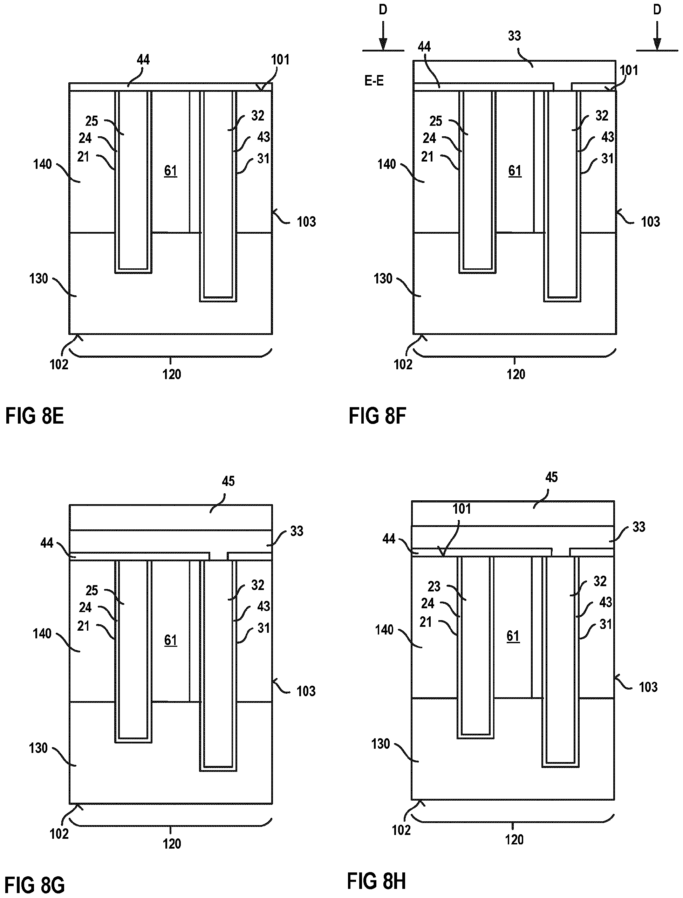

Referring to Figure 8E, the method further includes forming the gate insulating layer 44 on top of the first surface 101 of the semiconductor body 100 and on top of the gate via 32 and the sacrificial material 25. Forming the gate insulating layer 44 may include a thermal oxidation process. According to one example, forming the gate insulating layer 44 includes a first thermal oxidation process in which a first oxide layer is formed, depositing a second oxide layer on top of the first oxide layer, and a second thermal oxidation process in which the first oxide layer is grown further. After depositing the second oxide layer, the method may further include an RTP (rapid thermal processing) process.

Referring to Figure 8F, the method further includes forming the gate conductor 33 on top of the gate insulating layer 44 and electrically connecting the gate conductor 33 to the gate via 32. Electrically connecting the gate conductor 33 to the gate via 32 includes forming a contact opening in the gate insulating layer 44 above the gate via 31 before forming the gate conductor 33. Forming the gate conductor 33 may include depositing an electrically conducting layer. The electrically conducting layer is a metal layer or a highly doped polysilicon layer, for example.

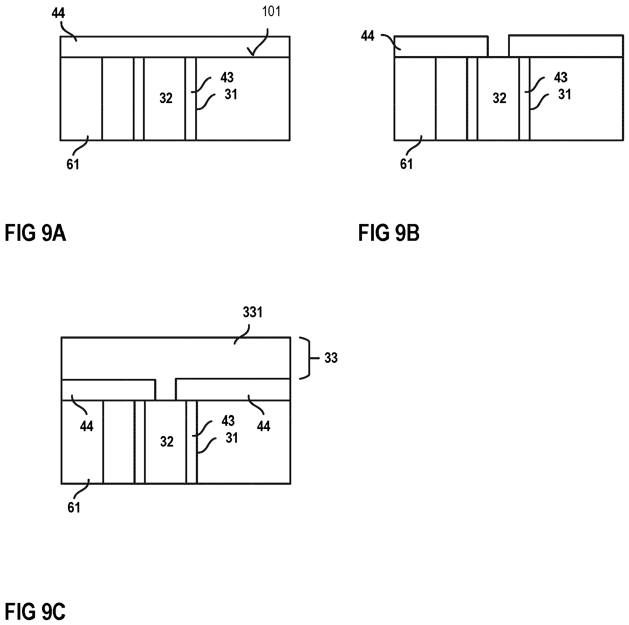

Figures 9A-9C illustrate one example of a method for forming the gate conductor 33 and connecting the gate conductor 33 to the gate via 32 in greater detail. Each of Figures 9A-9C shows a vertical cross-sectional view of one section of the gate via 32 and an adjoining section of the first surface 101. Figure 9A shows the gate via 32 after forming the gate insulating layer 44.

Referring to Figure 9B, the method further includes forming a contact opening in the gate insulating layer 44 above the gate via 32. Forming the contact opening 153 may include an etching process using an etch mask (not illustrated in Figure 9B). Referring to Figure 9C, the method further includes forming an electrically conducting layer 331 on top of the gate insulating layer 44. The electrically conducting layer 331 fills the contact opening 153 and forms the gate conductor 33 connected to the gate via 32.

Referring to Figure 8G, the method further includes forming the gate-source insulating layer 45. The gate-source insulating layer 45 may include a glass layer, such as an USG (undoped silicate glass) layer and/or a PSG (phosphorous silicate glass) layer, for example.

Referring to Figure 8H, the method further includes removing the sacrificial layer 25 from the insulating trench 21 to form the void 23. Figure 8H only illustrates the result of these method steps. Removing the sacrificial layer 25 includes forming at least one opening in the gate conductor 33 and the gate insulating layer 44 down to the sacrificial layer 25 at a position of the first surface 101 that is out of view in Fig-ure 8H. One example of a method for removing the sacrificial layer 25 and forming the void 23 is explained in detail herein further below.

Implementing the insulating trench with the void 23 separated from the semiconductor body 100 by the insulating layer 24 enables the insulating trench 21 to withstand high electric fields that may occur in the blocking state of the transistor devices. Referring to the above, the void 23 may include a vacuum, resulting in a high dielectric strength of the void 23. This makes it possible to implement the insulating trench 21 as a narrow trench in a space-saving manner.

Furthermore, the combination of the insulating layer 24 and the void 23 helps to form the equipotential lines entering the insulating trench 21 such that the equipotential lines are "smoothly" bent towards the first surface 101. In this way, particularly high electric fields occur in the void 23 spaced apart from the semiconductor body 100. This is due to the fact that the insulating layer 24 has a higher dielectric constant than the void 23. If, for example, the insulating layer 24 includes silicon dioxide, the dielectric constant is about 3.9, while the dielectric constant of the void is about 1.

Implementing the insulating layer 24 as a thermally grown oxide helps to avoid parasitic charges in the insulating trench 21. The presence of such parasitic charges may negatively affect the electric field in the insulating trench when the transistor devices in the blocking state and may therefore reduce the voltage blocking capability of the transistor devices. The thermal oxidation process that forms the insulating layer 24 as a thermally grown oxide layer removes or at least reduces such parasitic charges and/or removes or at least reduces traps along the surface where parasitic charges may be caught.

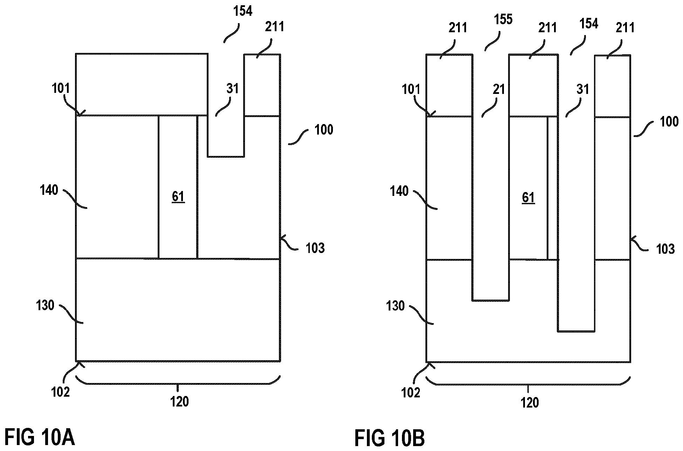

Referring to the above, the insulating trench 21 and the via trench 31 may be formed such that the via trench 31 extends deeper into the first semiconductor layer 130 than the insulating trench 21. In this way, the insulating trench 21 is spaced apart from the second surface 102 after the first semiconductor layer 120 has been removed down to the via trench 31. Figures 10A-10B illustrate one example of a method for forming the insulating trench 21 and the via trench 31 in this way. Each of Figures 10A-10B illustrates a vertical cross-sectional view of the edge region 120 of the semiconductor body 100.

Referring to Figure 10A, the method includes forming an etch mask 211 on top of the first surface 101, wherein the etch mask includes a first opening 154 above that position of the first surface 101 where the gate via 32 is to be formed. Furthermore, the method includes forming a first portion of the via trench 31 below the first opening 154 using an etching process. The etching process is an anisotropic etching process, for example.

Referring to Figure 10B, the method further includes forming a second opening 155 in the etch mask 211 above a position where the insulating trench 21 is to be formed. Furthermore, the method includes forming the insulating trench 21 below the second opening 155 and forming the remainder of the via trench 31 below the first opening 154 in an etching process. The etching process is an anisotropic etching process, for example.

A width of each of the two trenches 21, 31 is selected from between 0.5 µm and 5 µm, for example.

Another example of a method for forming the via trench 31 deeper than the insulating trench 21 includes forming the first and second openings 154, 155 in the etch mask 211 such that the first opening 154 is wider than the second opening 155. In this case, within a given time period, the via trench 31 below the wider opening 154 is etched deeper than the insulating trench 21 below the narrower opening 155. In this example, the first and second openings 154, 155 can be formed at the same time and only one common etching process is required to form the two trenches 21, 31.

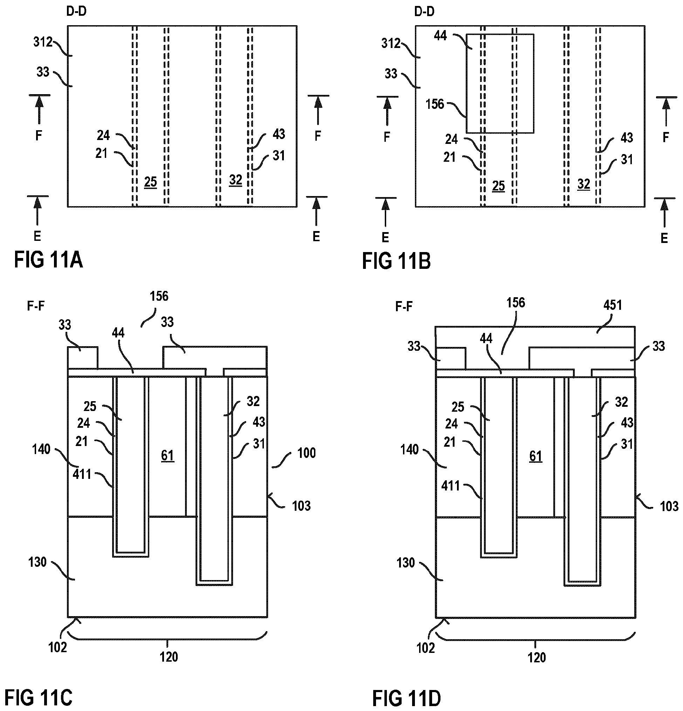

Figures 11A-11G illustrate one example of a method for removing the sacrificial layer 25 from the insulating trench 21 and forming the void 23 in the insulating trench 21. Figures 11A-11B illustrate top views of the gate conductor 33 in a plane D-D illustrated in Figure 8F. Section plane E-E illustrated in Figures 11A-11B represents the section plane illustrated in Figures 8A-8H. The position of each of the insulating trench 21 and the via trench 31 in the semiconductor body 100 below the gate conductor 33 is illustrated in dashed lines in Figures 11A-11B.

Referring to the above, removing the sacrificial layer 25 from the insulating trench 21 includes forming an opening in the gate conductor 33 and the gate insulating layer 44 arranged below the gate conductor 33. This opening may be formed as one opening that extends through both the gate conductor 33 and the gate insulating layer 44.

According to another example illustrated in Figure 11B, the method includes forming a first opening 156 in the gate conductor 33, wherein the first opening 156 extends through the gate conductor 33 but does not extend through the gate insulating layer 44 down to the sacrificial layer 24. Forming the first opening 156 may include a conventional etching process. As can be seen from Figure 11B, the at least one opening 156 is formed such that portions of the gate conductor 33 remain between sections of the gate conductor 33 arranged above the inner region 110 and connected to the transistor cells 1 (not illustrated in Figure 11B) and those sections of the gate conductor 33 connected to the gate via 32, so as to ensure that the transistor cells 1 are connected to the gate via 32.

Figure 11C illustrates a vertical cross-sectional view of the semiconductor body 100 in section plane F-F illustrated in Figure 11B, wherein section plane F-F cuts through the first opening 156.

Referring to Figure 11D, the method further includes forming a first insulating layer 451 that covers the gate conductor 33 and the gate insulating layer 44 inside the first opening 156. According to one example, the first insulating layer 451 forms a first portion of the gate-source insulating layer 45 explained herein before.

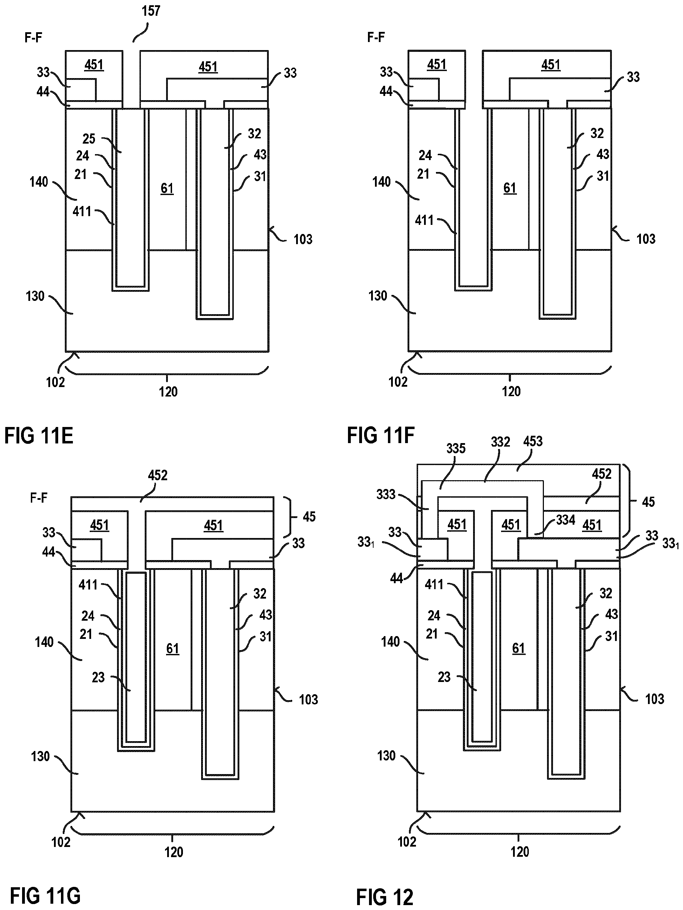

Referring to Figure 11E, the method further includes forming a second opening 157 that extends through the first insulating layer 451 and the gate insulating layer 44 down to the sacrificial layer 25. Forming the second opening 157 may include a conventional (anisotropic) etching process using an etch mask (not illustrated in Fig-ure 11E). According to one example, the second opening 157 is formed such that sidewalls of the second opening 157 are spaced apart from sidewalls of the first opening 156 in the gate conductor 33.

Referring to Figure 11F, the method further includes removing the sacrificial layer 25 from within the insulating trench 21, while the thermally grown oxide layer 411 remains on the bottom into sidewalls of the insulating trench 21. Removing the sacrificial layer 25 from the insulating trench 21 may include an isotropic etching process that removes the sacrificial layer 25 also from those sections of the insulating trench 21 that are not located below the second opening 157, such as those sections illustrated in Figure 8G, for example.

Referring to Figure 11G, the method further includes closing the second opening 157 and forming the void 23 within the insulating trench 21. According to one example, illustrated in Figure 11G, closing the second opening 157 and forming the void 23 includes an HDP (high density plasma) process in which a second insulating layer 452 is deposited. The second insulating layer 452 is an oxide layer, for example. Such HDP process takes place in a vacuum, so that a vacuum (automatically) forms in the void 23 when the second insulating layer 452 is deposited. According to another example, the second insulating layer 452 is formed in a sputter process that may take place in a vacuum chamber.

Before the second insulating layer 452 closes the second opening 157 portions of the second insulating layer 452 may also be deposited on top of the thermally grown oxide layer 24 within the insulating trench 21.

In this example, the thermally grown oxide layer 411 and the deposited second insulating layer 452 form the insulating layer 24 within the insulating trench 21 that separates the void 23 from semiconductor regions of the semiconductor body 100. Thus, the insulating layer 24 within the insulating trench 21 at least includes the thermally grown oxide layer 411, but may include one or more additional insulating layers, such as HDP layer 452 illustrated in Figure 11G.

Referring to Figure 11G, portions of the second insulating layer 452 are also formed on top of the first insulating layer 451. In this example the first and second insulating layers 451, 452 together form the gate-source insulating layer 45 in regions above the gate insulating layer 44 and the gate conductor 33.

Referring to Figure 11B, the opening 156 in the gate conductor 33 may be formed such that a section of the gate conductor 33 in the inner region 110 is not completely separated from a section of the gate conductor 33 in the edge region 120. This, however, is only an example. According to another example, the opening 156 may be formed such that it extends along the entire length of the insulating trench 21, so that the opening 156 separates a section of the gate conductor 33 arranged in the inner region 110 from a section of the gate conductor 33 in the edge region 120. In this example, the two gate conductor sections may connected with each other by an electrically conducting bridge. Figure 12 illustrates a vertical cross-sectional view of the edge region 120 of a transistor device in which a first section 33₁ of the gate conductor 33 arranged in the inner region 110 (not illustrated in Figure 12) is connected to a second section 33₂ of the gate conductor 33 arranged in the edge region 120 by an electrically conducting bridge 332. The electrically conducting bridge 332 may be formed after forming the void 23 in the insulating trench 21, that is, after forming the first and second insulating layers 451, 452.

Forming the bridge 332 may include forming a first electrically conducting via 333 that extends through the first and second insulating layers 451, 452 to the first gate conductor section 33₁, a second electrically conducting via 334 that extends through the first and second insulating layers 451, 452 to the second gate conductor section 33₂, and an electrically conducting layer 335 on top of the second insulating layer 452 and connecting the two electrically conducting vias 333, 334. The first and second electrically conducting vias 333, 334 and the electrically conducting layer 335 form the electrically conducting bridge. The electrically conducting bridge 332 forms a portion of the gate conductor 33, so that the first and second gate conductor sections 33₁, 33₂ and the bridge 332 form the gate conductor 33.

Referring to Figure 12, a third insulating layer 453 may be formed on top of the second insulating layer 452 and the electrically conducting bridge 332. In this example, the first, second, and third insulating layers 451, 452, 453 form the gate-source insulating layer 45.

It should be noted that an electrically conducting bridge 332 of the type illustrated in Figure 12 can be formed in the process according to Figures 11A-11G in addition to bridges of the gate conductor 33 that remain after forming the opening 44 in the way illustrated in Figure 11B.

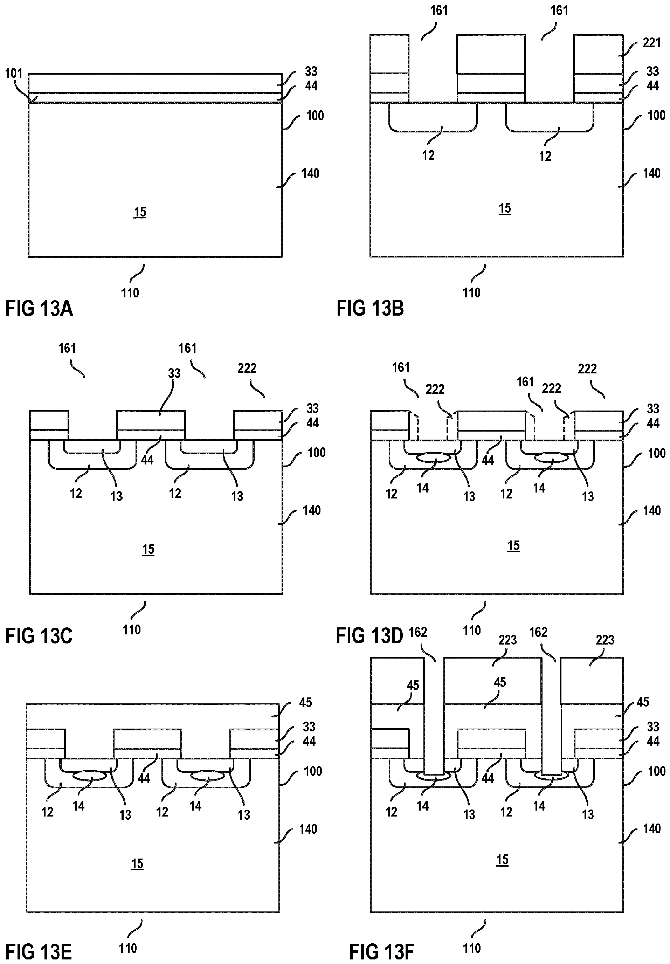

Referring to the above, the transistor cells 1 may be implemented in various ways. Figures 13A-13G illustrate one example of a method for forming transistor cells 1 in the inner region 110 of the semiconductor body 100. Each of Figures 13A-13G shows a vertical cross-sectional view of one section of the semiconductor body 100 in the inner region 110 during various process sequences for forming the transistor cells 1. Furthermore, each of Figures 13A-13G only shows one section of the second semiconductor layer 140. The first semiconductor layer 130 is not illustrated in these figures.

Referring to Figure 13A, the process of forming the transistor cells 1 may start after the gate insulating layer 44 and the gate conductor 33 have been formed one above the other on top of the first surface 101.

According to one example, the second semiconductor layer 140 has a basic doping of a first doping type (conductivity type) and forms a drift region 15 of the transistor cells 1. Referring to the above, the second semiconductor layer 140 is an epitaxially grown semiconductor layer, for example.

Referring to Figure 13B, the method includes forming body regions 12 of the transistor cells in the semiconductor body 100. According to one example, forming the body regions 12 includes forming first openings 161 in the gate insulating layer 44 and the gate conductor 33. Forming the first openings 161 in the gate insulating layer 44 and the gate conductor 33 may include a conventional etching process using an etch mask 221.

Furthermore, the method includes introducing dopant atoms of a second doping type complementary to the first doping type through the first openings 161 into the semiconductor body 100. Introducing the dopant atoms into the semiconductor body 100 may include implanting the dopant atoms into the semiconductor body 100 and diffusing the implanted dopant atoms in a thermal process within the semiconductor body 100.

Referring to Figure 13C, the method further includes forming source regions 13 of the first doping type within the body regions 12. Forming the source regions 13 may include implanting first type dopant atoms through the first openings 161 in the gate insulating layer 44 and the gate conductor 33 into the body regions 12 and activating the implanted dopant atoms in a thermal process.

Optionally, as illustrated in Figure 13D, the method further includes forming body contact regions 14 in the body regions 12. The body contact regions 14 are doped regions of the second doping type and have a higher doping concentration than the body regions 12. Forming the body contact regions 14 may include implanting second type dopant atoms into the body regions 12 through the first openings 161 and activating the implanted dopant atoms in a thermal process.

Optionally, spacers 222 (illustrated in dashed lines) are formed along sidewalls of the first openings 161 before implanting the second type dopant atoms forming the body contact regions 14. Forming the spacers 222 may include depositing a spacer layer in the first openings 161 and removing the spacer layer at the bottom of the openings 161 and from an upper surface of the gate conductor 33.

Referring to Figure 13E, the method further includes forming the gate-source insulating layer 45. The optional spacers 222 (not illustrated in Figure 13E) may remain and may be covered by the gate-source insulating layer 45. The gate-insulating layer 45 covers the gate conductor 33 and fills the first openings 161 in the gate insulating layer 44 and the gate conductor 33. The gate-source insulating layer 45 may be produced using any one of the process sequences explained hereinabove, including a process sequence in which two partial layers are deposited that together form the gate-insulating layer 45.

Referring to Figure13F, the method further includes forming contact openings 162 that extend through the gate insulating layer 45 and the source regions 13 to the body contact regions 14. Forming the contact openings may include a conventional etching process using an etch mask formed on top of the gate-insulating layer 45.

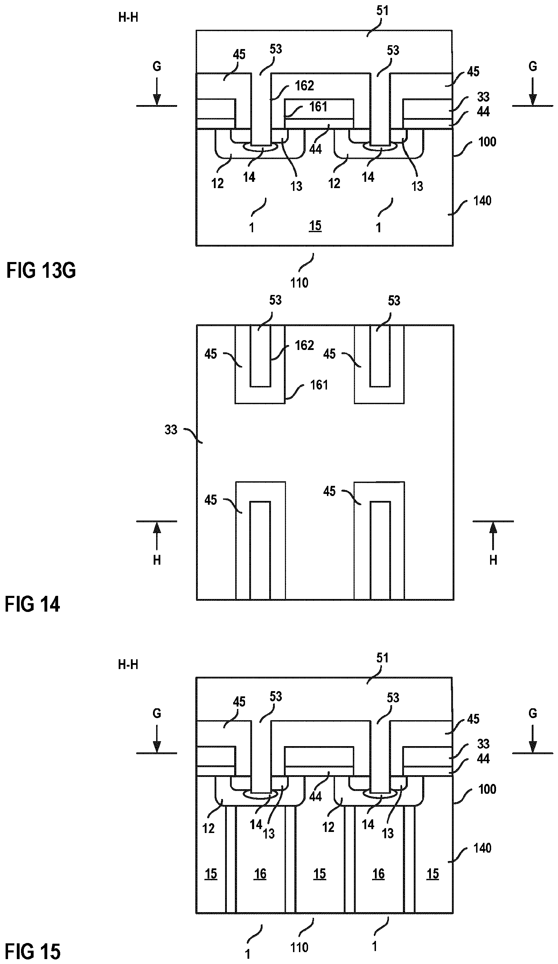

Referring to Figure 13G, the method further includes forming the source electrode 51. Forming the source electrode 51 may include depositing one or more electrically conductive layers, wherein the one or more electrically conductive layers fill the second openings 162, so that contact plugs 53 are formed that connect the source regions 13 and the body regions 12 (through the body contact regions 14) to the source electrode 51.

In the transistor cell according to Figure 13G, the gate insulating layer 44 adjoins the body and source regions 13, 12 and forms the gate dielectric of the individual transistor cells 1. Furthermore, in the inner region 110, above the source and body regions 13, 12, the gate conductor 33 forms gate electrodes of the individual transistor cells 1. Each of the transistor cells 1, in addition to the gate dielectric and the gate electrode, includes a body region 12, a source region 13, and an optional body contact region 14. Referring to the above, sections of the second semiconductor layer 140 that have the basic doping of the second semiconductor layer 140 may form a common drift region 15 of the individual transistor cells 1. Furthermore, the first semiconductor layer 130 may form a common drain region 11 of the transistor cells 1.

The transistor device may be implemented as an N-type transistor device or as a P-type transistor device. In an N-type transistor device, the first doping type, which is the doping type of the source regions 13 and the drift region 15 is an N-type and the second doping type, which is the doping type of the body regions 12 is a P-type. In a P-type transistor device, the first doping type is a P-type and the second doping type is an N-type.

The transistor device may be implemented as a MOSFET. In this case, the drain region 11 is of the first doping type (N-type in an N-type device). According to another example, the transistor device is implemented as an IGBT. In this case, the drain region is of the second doping type (P-type in an N-type device).

Figure 14 illustrates a horizontal cross-sectional view of the arrangement illustrated in Figure 13G in a section plane G-G that cuts through the gate conductor 31. As can be seen from Figure 13, the first openings 161, that extend through the gate conductor 33 and the gate insulating layer 44 down to the semiconductor body 100, may be formed in such a way that a grid-shaped gate conductor 33 remains after forming the first openings 161, so as to ensure that each portion of the gate conductor 33 forming a gate electrode of a respective transistor cell 1 is connected to the gate via 31.

According to another example (not illustrated), the first openings 161 are formed such that based on the electrically conducting layer 331 (see, e.g., Figure 9C) several stripe-shaped gate conductor sections are formed that are separated from each other. These stripe-shaped gate conductor sections are connected with each other by electrically conducting bridges that are spaced apart from the source contact plugs and insulated from the source contact plugs 53. In order to cross the gate via 32, a gate conductor section arranged above the inner region 110 may be connected to a gate conductor section arranged above the edge region 120 in accordance with any of the examples explained hearing before. In particular, the gate conductor 33 may be formed such that it is not entirely interrupted above the gate via 32 (as illustrated in Figure 11B). Alternatively, a gate conductor section in the inner region may be connected to a gate conductor section in the edge region using an electrically conducting a bridge of the type illustrated in Figure 12, for example.

According to one example, the transistor device is a superjunction transistor device. In this example, each transistor cell 1, in addition to a drift region 15, includes a compensation region 16 of the second doping type, which is complementary to the doping type of the drift region 15. Figure 15 illustrates a vertical cross-sectional view of transistor cells 1 that each include a drift region 15 and a compensation region 16. The compensation region 16 may adjoin the body region 12 of the respective transistor cell 1, so that each compensation region 16 is connected to the source electrode 51 (and the source node S). The drift region 15 of each transistor cell also adjoins the respective body region 12 in a section where the body region 12 adjoins the gate dielectric 44.

The drift and compensation regions 15, 16, towards the second surface 102, may extend to the drain region 11 and each adjoin drain region 11. According to another example, a buffer region (not illustrated) of the first doping type is arranged between the drain region 11 and the drift and compensation regions 15, 16.

The drift and compensation regions 15, 16 may be produced in a conventional way before forming the body and source regions 13, 12 in a way explained hereinabove. Forming the drift and compensation regions 15, 16 may include an MEMI (multi-epi multi-implant) process, which is a process in which several epitaxial layers are grown one above the other and first and second type dopant atoms are implanted into each of these epitaxial layers. The implanted dopant atoms are diffused in a thermal process after forming the epitaxial layers, so as to form the drift and compensation regions 15, 16.

According to another example, forming the drift and compensation regions 15, 16 includes forming the second semiconductor layer 142 have a basic doping that includes both first and second type dopant atoms, wherein one type of these dopant atoms is selected to have a higher diffusion coefficient than the other one of the dopant atoms. According to one example, first type dopant atoms are arsenic (As) atoms, and second type dopant atoms are boron (B) atoms, wherein arsenic diffuses much faster in silicon than boron. The method further includes forming trenches in the second semiconductor layer 140, filling the trenches with a non-doped (intrinsic) monocrystalline semiconductor material, and diffusing the dopant atoms in a thermal process. Due to the lower diffusion coefficient of the second type dopant atoms, the second type dopant atoms will essentially remain in sections of the second semiconductor layer between the trenches, while the first type dopant atoms will significantly diffuse into the trenches filled with the non-doped semiconductor material. In this way, first regions having an effective doping concentration of the first doping type and second regions having an effective doping concentration of the second doping type are formed, wherein the first regions form the drift region 15 and the second regions from the compensation region 16.

It should be noted that the examples outlined above for forming the drift and compensation regions 15, 16 are only two of several known examples for forming the drift and compensation regions 15, 16. Any other way of forming drift and compensation regions may be used as well.

Referring to Figure 1, the transistor device may include a field-stop region 61 between the insulating trench 21 and the via trench 31. The field-stop region 61 is a region of the second doping type. The field-stop region 61, from the first surface 101 extends towards the second surface 102. In the vertical direction, the dimension of the field-stop region 61 is at least 30%, at least 50%, or at least 80% of the thickness of the second semiconductor layer 140. The thickness of the second semiconductor layer 140 is the dimension of the second semiconductor layer 140 in the vertical direction. The thickness of the second semiconductor layer 140 is dependent on a desired voltage blocking capability of the transistor device, for example. According to one example, the thickness of the second semiconductor layer 140 is selected from between 30 µm and 200 µm.

The field-stop region 61 may be formed by the same process that forms the compensation regions 16 in a superjunction transistor device. In case the transistor device is not a superjunction transistor device, the field-stop region 61 may be formed by implanting second type dopant atoms (in a tilted implantation process) into the insulating trench 21 before forming the insulating layer 24.

In the examples illustrated in Figures 13G and 15, the transistor cells 1 are planar transistor cells, which are transistor cells that have their respective gate electrode arranged above the first surface 101 of the semiconductor body 100. Implementing the transistor cells as planar transistor cells, however, is only an example.

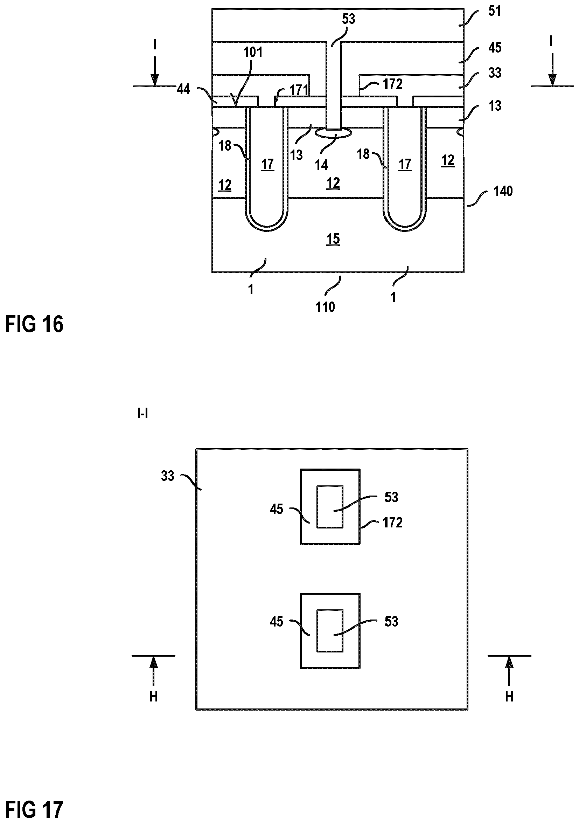

According to another example, the transistor cells are implemented as trench transistor cells. Trench transistor cells are transistor cells that have their respective gate electrode arranged in a trench that extends into the semiconductor body 100. An example of trench transistor cells are illustrated in Figure 16.

Figure 16 shows a vertical cross-sectional view of one section of the semiconductor body 100 in the inner region, wherein trench transistor cells 1 are integrated in the section illustrated in Figure 16.

Referring to Figure 16, each of the transistor cells includes a gate trench that extends from the first surface 101 into the semiconductor body and includes a gate electrode 17 that is dielectrically insulated from the body and source regions 12, 13 by a gate dielectric 18. The gate electrodes 17 are connected to the gate conductor 33, wherein the gate conductor 33 is separated from semiconductor regions of the semiconductor body 100 by the gate insulating layer 44 formed on top of the first surface 101. The source contact plug 53 extends through the gate source insulating layer 45, the gate insulating layer 44 and the source region 13 to the body contact region 14.

The trench transistor cells according to Figure 16 may be formed by forming the source and body regions 13, 12, the gate electrodes 17, and the gate dielectrics 18 before forming the gate insulating layer 44 and the gate conductor 33. After forming the gate insulating layer 44, and before forming the gate conductor 33, openings 171 may be formed in the gate insulating layer 44 above the gate electrodes 17. After forming the gate conductor 33, the gate conductor 33 is connected to the gate electrodes 17 in these openings 171. Forming the gate conductor 33 may include forming openings in the gate conductor 33 before forming the gate-insulating layer 45.

Referring to Figure 16, the source contact plug 53 extends through the gate conductor 33 in these openings 172, wherein the gate-source insulating layer 45 separates the source contact plug 53 from the gate conductor 33 in the opening.

Referring to Figure 17 which shows a horizontal cross-sectional view of the gate conductor 33 in a section plane I-I, the openings 172 in the gate conductor 33 may be formed in such a way that the gate conductor 33 is grid-shaped, so as to ensure that each gate electrode 17 is connected to the gate via through the gate conductor 33.

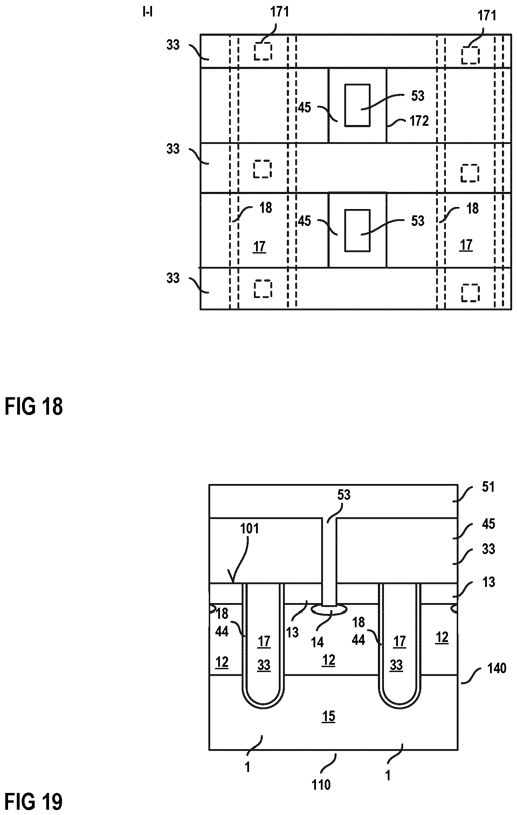

Alternatively, as illustrated in Figure 18, the gate conductor 33 may be formed to include several elongated sections (gate runners), wherein each gate runner is connected to the gate via 31 and is connected to at least one of the gate electrodes 17. According to one example, the gate electrodes 17 are elongated electrodes, and the gate runners extend essentially perpendicular to the elongated gate electrodes 17. The position of the gate electrodes 17 below the gate runners are illustrated in dashed lines in Figure 18. The position of the openings 171 in the gate insulating layer 44 in which the gate conductor 33 is connected to the gate electrodes 17 are also illustrated in dashed lines in Figure 17. While in the example according to Figure 17, the openings 171 in the gate insulating layer 44 and the source contact plugs 53 may be located in the same vertical planes of the semiconductor body 100, the openings 171 in the gate insulating layer 44 and the source contact plug are arranged in different vertical planes in the example illustrated in Figure 18.

Figure 19 illustrates a modification of the transistor devices illustrated in Figures 16. In this example, the gate insulating layer 44 and the gate conductor 33 on top of the first surface 101 are omitted, so that the gate-source insulating layer 45 insulates the source conductor 51 from the gate electrodes 17 and the source regions 13. In this example, the gate dielectrics 18, at the same time, form the gate insulating layer 44. Furthermore, the gate electrodes 17, at the same time, form the gate conductor 33.

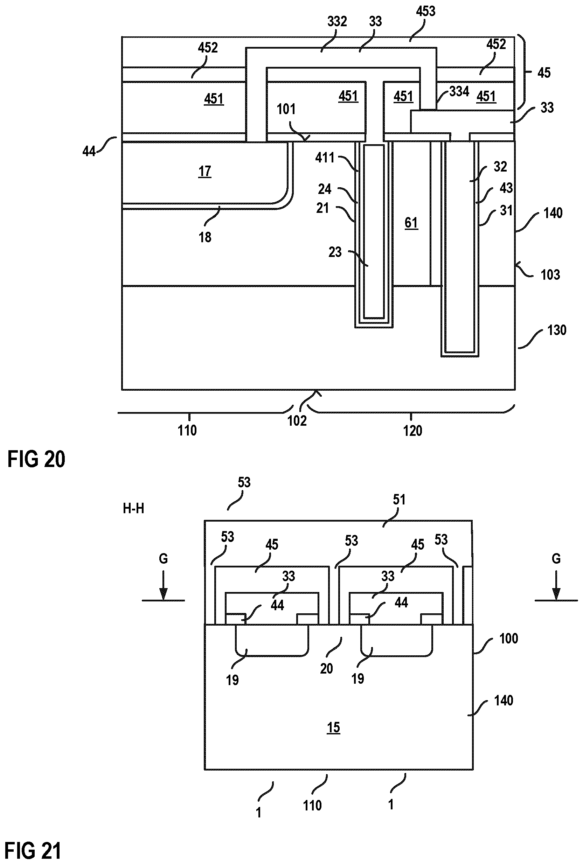

According to one example illustrated in Figure 20, the gate electrodes 17 are elongated electrodes that, in the inner region 110, extend towards the edge region 120. In the edge region 120, the gate conductor 33 may be formed on top of the first surface 101 in the way explained herein before. In this example, the gate electrodes 17, at their respective longitudinal ends, may be connected through an electrically conducting bridge 332 to the gate conductor section in the edge region 120, wherein the gate conductor section arranged in the edge region 120 is connected to the gate via 32. The bridge 332 forms a portion of the gate conductor 33.

Alternatively (not illustrated) the electrically conducting bridge 332 illustrated in Figure 20 may directly be connected to the gate via 32, so that sections of the gate conductor 33 above the first surface 101 are omitted. In this example, the gate conductor 33 is only formed by the electrically conducting bridge 332.

It should be noted that in the same way in which the gate electrode 17 illustrated in Figure 20 is connected to the gate via 32 any other type of gate electrode or any other type of gate conductor arranged above the inner region 110 may be connected to either the gate conductor 33 arranged in the edge region 120 or directly to the gate via 32.

Referring to the above, the transistor device may be implemented in various ways. In particular, the transistor device is not restricted to be implemented as a MOSFET or as and IGBT. Instead, the topology explained herein before with the insulating trench 21 and the gate via 32 arranged in the edge region 120 and with one or more transistor cells arranged in the inner region 110 may be used in any kind of vertical transistor device. A further example of a vertical transistor device includes a vertical JFET.

Figure 20 shows a vertical cross-sectional view of one section of the semiconductor body 100 in the inner region 110 in which transistor cells 1 of a JFET are implemented. The transistor cells 1 include a (common) drift region 15 of the first doping type and each include a base region 19 of the second doping type arranged in the drift region 15. The base regions 19 of the transistor cells 1 are spaced apart from each other, so that channel regions 20 of the drift region 15 are formed. These channel regions 20 are (ohmically) connected to the source electrode 51 through electrically conducting vias (source vias) 53. The base regions 19 are each connected to the gate conductor 33 which is insulated from the channel regions 20 by the gate insulating layer 44. The gate conductor 33 is insulated from the source electrode 51 by the gate-source insulating layer 45.

The gate conductor 33 may be implemented in accordance with any of the examples explained herein before and may be connected to the gate via 32 in accordance with any of the examples explained herein before.

Some of the aspects explained hereinabove are summarized in the following with reference to numbered examples.

Example 1. A transistor device, including: at least one transistor cell having active device regions integrated in an inner region of a semiconductor body; a gate via extending, in an edge region of the semiconductor body, through the semiconductor body from a first surface to a second surface of the semiconductor body; a drain pad and a gate pad each formed on top of the second surface of the semiconductor body; and an insulating structure arranged between the inner region and the gate via and extending through the semiconductor body from the first surface to the second surface, wherein the gate via is connected between the at least one transistor cell and the gate pad, and wherein the insulating structure includes: an insulating trench extending from the first surface into the semiconductor body and being spaced apart from the second surface, and an insulating plug extending from the second surface to the insulating trench.

Example 2. The transistor devices of example 1, wherein the insulating trench includes a void and an insulating layer separating the void from the semiconductor body.

Example 3. The transistor devices of example 2, wherein the insulating layer includes a thermally grown oxide layer.

Example 4. The transistor device of any one of the preceding examples, wherein the semiconductor body includes a first semiconductor layer and a second semiconductor layer formed on top of the first semiconductor layer, wherein, in the inner region of the semiconductor body, the first semiconductor layer forms a drain region of the transistor device.

Example 5. The transistor device of any one of examples 1 to 4, further including: a via insulating layer insulating the gate via from the semiconductor body.

Example 6. The transistor device of any one of examples 1 to 5, further including: a field-stop region arranged in the edge region between the insulating structure and the gate via.

Example 7. The transistor device of any one of examples 1 to 6, further including: a gate conductor connected between the gate via and the at least one transistor cell.

Example 8. The transistor device of example 7, wherein the gate conductor forms at least portions of gate electrodes of the transistor cells.

Example 9. The transistor device of example 7, wherein the gate conductor is in addition to gate electrodes of the transistor cells.

Example 10. The transistor device of example 8 or 9, wherein each of the transistor cells includes a gate electrode arranged in a trench of the semiconductor body, and wherein the gate electrode of each of the transistor cells is connected to the gate via through the gate conductor.

Example 11. The transistor device of example 10, wherein the gate electrodes are elongated electrodes, and wherein the gate conductor is connected between longitudinal ends of the gate electrodes and the gate via.

Example 12. The transistor device of any one of examples 1 to 11, further including: a source electrode connected to a source region of the at least one transistor cell.

Example 13. The transistor device of example 12, wherein the transistor cells are MOSFET cells or IGBT cells.

Example 14. The transistor device of any one of examples 1 to 11, further including: a source electrode connected to a drift region of the at least one transistor cell.

Example 15. The transistor device of example 14, wherein the transistor cells are JFET cells.

Example 16. A method, including forming at least one transistor cell in an inner region of a semiconductor body; forming a gate via extending through the semiconductor body from a first surface to a second surface in an edge region of the semiconductor body; forming a drain pad and a gate pad each formed on top of the second surface of the semiconductor body; and forming an insulating structure arranged between the inner region and the gate via and extending through the semiconductor body from the first surface to the second surface, wherein the gate via is formed to be connected between the at least one transistor cell and the gate pad formed on top of the second surface, and wherein forming the insulating structure includes: forming an insulating trench that extends from the first surface into the semiconductor body and is spaced apart from the second surface, and forming an insulating plug to extend from the first surface to the insulating trench.

Example 17. The method of example 16, wherein forming the insulating trench includes forming a void separated from the semiconductor body by an insulating layer.

Example 18. The method of example 17, wherein forming the insulating layer includes a thermal oxidation process.

Example 19. The method of example 17 or 18, wherein forming the void includes generating a pressure of below 1 bar, below 0.5 bar, or below 0.1 bar in the void.

## Claims

1. A transistor device, comprising:
at least one transistor cell (1) having active device regions integrated in an inner region (110) of a semiconductor body (100);
a gate via (32) extending, in an edge region (120) of the semiconductor body, through the semiconductor body (100) from a first surface (101) to a second surface of the semiconductor body;
a drain pad (52) and a gate pad (34) each formed on top of the second surface (102) of the semiconductor body; and
an insulating structure (2) arranged between the inner region (110) and the gate via (32) and extending through the semiconductor body (100) from the first surface (101) to the second surface (102),
wherein the gate via (32) is connected between the at least one transistor cell (1) and the gate pad (34), and
wherein the insulating structure (2) comprises:
an insulating trench (21) extending from the first surface (101) into the semiconductor body (100) and being spaced apart from the second surface (102), and
an insulating plug (22) extending from the second surface (102) to the insulating trench (21).

2. The transistor devices of claim 1,
wherein the insulating trench (21) comprises a void (23) and an insulating layer (24) separating the void (23) from the semiconductor body (100).

3. The transistor devices of claim 2,
wherein the insulating layer (24) comprises a thermally grown oxide layer.

4. The transistor device of any one of the preceding claims,
wherein the semiconductor body (100) comprises a first semiconductor layer (130) and a second semiconductor layer (140) formed on top of the first semiconductor layer (130),
wherein, in the inner region (110) of the semiconductor body (100), the first semiconductor layer (130) forms a drain region (11) of the transistor device.

5. The transistor device of any one of the preceding claims, further comprising:
a via insulating layer (43) insulating the gate via (32) from the semiconductor body (100).

6. The transistor device of any one of the preceding claims, further comprising:
a field-stop region (61) arranged in the edge region (120) between the insulating structure (2) and the gate via (32).

7. The transistor device of any one of the preceding claims, further comprising:
a gate conductor (33) connected between the gate via (32) and the at least one transistor cell (1).

8. The transistor device of claim 7,
wherein the gate conductor (33) forms at least portions of gate electrodes of the transistor cells (1).

9. The transistor device of claim 8,
wherein each of the transistor cells (1) comprises a gate electrode (17) arranged in a trench of the semiconductor body (100), and
wherein the gate electrode (17) of each of the transistor cells (1) is connected to the gate via (32) through the gate conductor (33).

10. The transistor device of any one of claims 1 to 9, further comprising:
a source electrode (51) connected to a source region (13) of the at least one transistor cell (1).

11. The transistor device of any one of claims 1 to 9, further comprising:
a source electrode (51) connected to a drift region (15) of the at least one transistor cell (1).

12. A method, comprising
forming at least one transistor cell (1) in an inner region (110) of a semiconductor body (100);
forming a gate via (32) extending through the semiconductor body (100) from a first surface (101) to a second surface (102) in an edge region (120) of the semiconductor body;
forming a drain pad (52) and a gate pad (34) each formed on top of the second surface (102) of the semiconductor body; and
forming an insulating structure (2) arranged between the inner region (110) and the gate via (32) and extending through the semiconductor body (100) from the first surface (101) to the second surface (102),
wherein the gate via (32) is formed to be connected between the at least one transistor cell (1) and the gate pad (34) formed on top of the second surface (102), and
wherein forming the insulating structure (2) comprises:
forming an insulating trench (21) that extends from the first surface (101) into the semiconductor body (100) and is spaced apart from the second surface (102), and
forming an insulating plug (22) to extend from the first surface (102) to the insulating trench (21).

13. The method of claim 12,
wherein forming the insulating trench (21) includes forming a void (23) separated from the semiconductor body (100) by an insulating layer (24).

14. The method of claim 13,
wherein forming the insulating layer (24) comprises a thermal oxidation process.

15. The method of claim 13 or 14,
wherein forming the void (23) comprises generating a pressure of below 1 bar, below 0.5 bar, or below 0.1 bar in the void (23).
